# EUROPÄISCHE PATENTANMELDUNG

(11) **EP 0 902 542 A1**
(43) Veröffentlichungstag der Anmeldung: **17.03.1999**
(21) Anmeldenummer: 98440181.0
(22) Anmeldetag: 21.08.1998
(51) Int. Cl.: H03K 19/018, H03K 19/00

(54) **Schaltungsanordnung für eine digitale Schaltung in differentieller Logik**

(30) Priorität: 12.09.1997 DE 19740108
(71) Anmelder: ALCATEL, 75088 Paris (FR)
(72) Erfinder: Pöhlmann, Wolfgang, 71282 Hemmingen (DE)
(74) Vertreter: Müller, Joachim, Dipl.-Ing.

(57) **Zusammenfassung**

Schaltungen in differentieller Logik werden in optischen Übertragungssystemen bei großer Übertragungsgeschwindigkeit eingesetzt. Ein wesentliches Problem bei dem Entwurf hochintegrierter Schaltungen für den genannten Zweck ist die Beherrschung der unerwünschten Wärmeentwicklung, so daß eine geringe Stromaufnahme der Schaltungen angestrebt wird. Erfindungsgemäß wird eine Reduzierung der Stromaufnahme dadurch erreicht, daß die Anzahl der bezüglich der Stromversorgung parallel geschalteten Stufen verringert wird. Dazu wird ein Teil der parallel geschalteten Stufen als Reihenschaltung mit dem verbleibenden Teil der parallel geschalteten angeordnet, so daß die Gesamtzahl der parallel liegenden Zweige verkleinert wird.

## Beschreibung

Die Erfindung betrifft eine Schaltungsanordnung für eine digitale Schaltung in differentieller Logik, insbesondere für Emitterfolger. Emitterfolger sind als Grundschaltungen allgemein bekannt, vgl. Tietze, Schenk: Halbleiter-Schaltungstechnik, 8. Auflage, Springer-Verlag Berlin 1986, Seiten 56 bis 59. Diese Grundschaltung wird zur Entkopplung von Schaltungsteilen oder als Pegelschieber eingesetzt.

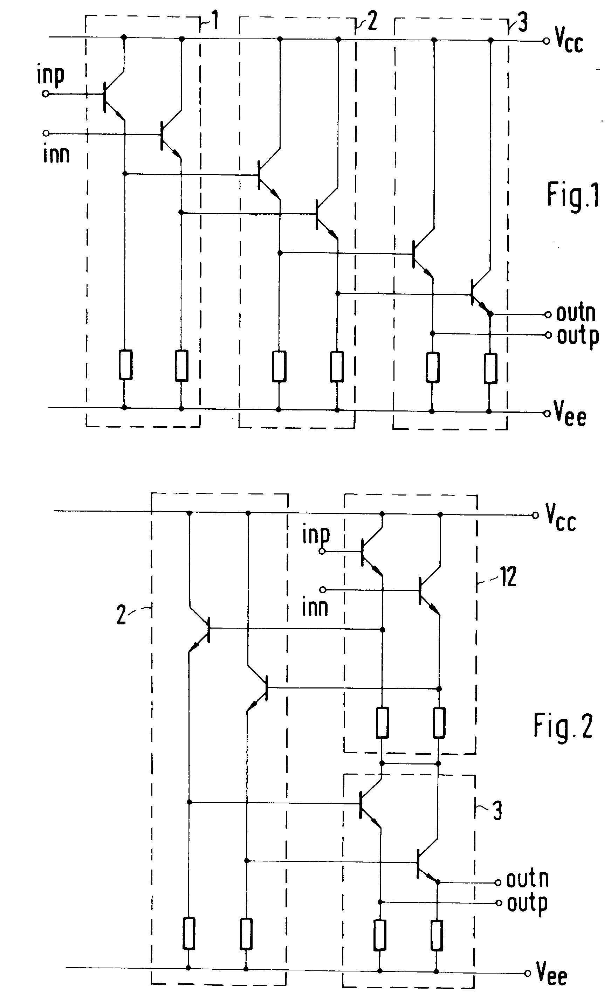

In Schaltungsanordnungen für optische Übertragungssysteme mit hoher Übertragungsrate, beispielsweise l0Gbit/s, werden Emitterfolger in differentieller Logik eingesetzt wie sie in Fig. 1 als Reihenschaltung dreier Schaltstufen 1, 2, 3 dargestellt sind. An den Eingängen inp und inn einer Schaltstufe liegen die logischen Signale "0" oder "1" jeweils in zueinander komplementärer Form an, so daß die Stromaufnahme eines so angesteuerten Emitterfolgerpaares unabhängig vom Informationsinhalt des zu übertragenen Signals konstant ist. Insbesondere bei hohen Übertragungsgeschwindigkeiten ist eine solche konstante Stromaufnahme vorteilhaft, da somit Störungen durch Schaltvorgänge minimiert werden und andererseits elektromagnetische Beeinflussungen der Umgebung bei konstantem elektromagnetischem Feld auch bei hohen Übertragungsgeschwindigkeiten stark reduziert werden.

Aus der Forderung, bei integrierten Schaltungen für optische Übertragungssysteme die Wärmeentwicklung möglichst gering zu halten, resultiert die Aufgabe, eine Schaltungsanordnung in differentieller Logik anzugeben, die im Vergleich zu bekannten Schaltungen eine geringere Stromaufnahme hat.

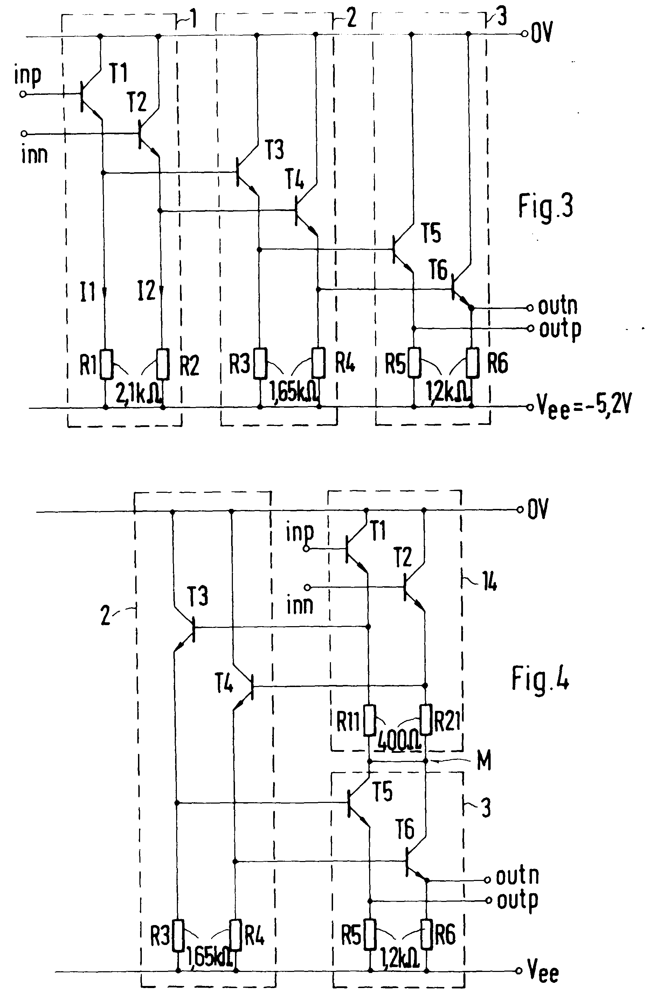

Zwar ist es möglich, bei der in Fig. 3 näher dargestellten Schaltungsanordnung zur Verringerung der Stromaufnahme in den Schaltstufen 1, 2, 3 die Widerstände R1, R2, R3, R4, R5, R6 zu vergrößern, jedoch hat diese Maßnahme zur Folge, daß die Transistoren T1, T2, T3, T4, T5, T6 unterhalb der optimalen Stromdichte betrieben werden und ihre Schaltgeschwindigkeit damit abnimmt und daß der Spannungshub der Schaltstufen 1, 2, 3 geringer wird und damit der Einfluß des Rauschens und die Störempfindlichkeit zunimmt.

Mit der Erfindung soll nun die Aufgabe gelöst werden, eine Schaltungsanordnung in differentieller Logik mit geringer Stromaufnahme anzugeben ohne die Schaltgeschwindigkeit der Schaltungsanordnung verringern zu müssen und ohne die Störempfindlichkeit zu vergrößern. Außerdem soll die Forderung erfüllt werden, die Kollektor-Emitter-Durchbruchspannung von Halbleitern bei modernen Hochgeschwindigkeitstechnologien sehr niedrig, beispielsweise 3V, zu halten.

Diese Aufgabe und diese Forderung wird durch die im ersten Patentanspruch beschriebene Schaltungsanordnung gelöst.

Das Wesen der Erfindung besteht darin, daß unter Beibehaltung der Schaltungseigenschaften eine Reduzierung der Stromaufnahme erreicht wird.

Die Erfindung wird nunmehr an einem Ausführungsbeispiel erläutert. In der dazugehörigen Zeichnung zeigen
- Fig. 1: ein Schaltbild einer Schaltungsanordnung nach dem Stand der Technik,
- Fig. 2: ein Schaltbild einer erfindungsgemäßen Schaltungsanordnung,
- Fig. 3: ein Dimensionierungsbeispiel der Schaltungsanordnung nach dem Stand der Technik,
- Fig. 4: ein Dimensionierungsbeispiel der erfindungsgemäßen Schaltungsanordnung,
- Fig. 5a: ein Blockschaltbild einer mehrstufigen Schaltungsanordnung nach dem Stand der Technik und
- Fig. 5b: ein Blockschaltbild einer mehrstufigen Schaltungsanordnung gemäß Erfindung.

Gemäß Fig. 1 besteht eine Schaltungsanordnung in differentieller Logik nach dem bekannten Stand der Technik bezüglich der Stromversorgung aus einer Parallelschaltung von beispielsweise drei Emitterfolgern 1, 2, 3 mit den Eingängen inp und inn sowie den Ausgängen outn und outp und den Versorgungsspannungsanschlüssen V_{cc} und Vₑₑ.

Fig. 2 zeigt die erfindungsgemäße Schaltungsanordnung, die bei gleicher Versorgungsspannung und gleichen Eingangs- und Ausgangsbedingungen wie die in Fig. 1 dargestellte Schaltungsanordnung aber eine um ein Drittel reduzierte Stromaufnahme wie die in Fig. 1 dargestellte Schaltungsanordnung hat. Das wird dadurch erreicht, daß statt einer Parallelschaltung aus drei Emitterfolgern gemäß Fig. 1 nur eine Parallelschaltung aus zwei Zweigen gemäß Fig. 2 erforderlich ist, wobei ein Zweig der in Fig. 2 dargestellten Parallelschaltung aus einer Reihenschaltung zweier Emitterfolger 12, 3 besteht und jeder Zweig eine unveränderte Stromaufnahme hat.

Die Fig. 3 und Fig. 4 zeigen Dimensionierungsbeispiele der Schaltungsanordnungen. Jeder in Fig. 3 durch einen Transistor T1, T2, T3, T4, T5, T6 und einen Widerstand R1, R2, R3, R4, R5, R6 dargestellte Strompfad nimmt bei einer Versorgungsspannung Vₑₑ = 5,2V einen Strom von 1 = 2mA auf, so daß die Gesamtstromaufnahme 1_{ges} = 12mA beträgt.

Fig. 4 zeigt den bisherigen ersten Emitterfolger 1 als neu dimensionierten Emitterfolger 14, der nunmehr über einen virtuellen Massepunkt M mit dem dritten Emitterfolger 3 eine Reihenschaltung bildet, so daß die erfindungsgemäße Schaltungsanordnung aus vier Strompfaden mit jeweils I = = 2mA Stromaufnahme besteht. Damit wird bei gleichen Schnittstellenbedingungen eine Reduzierung der Stromaufnahme von Iₐₗₜ = 12mA auf Iₙₑᵤ = 8mA erreicht.

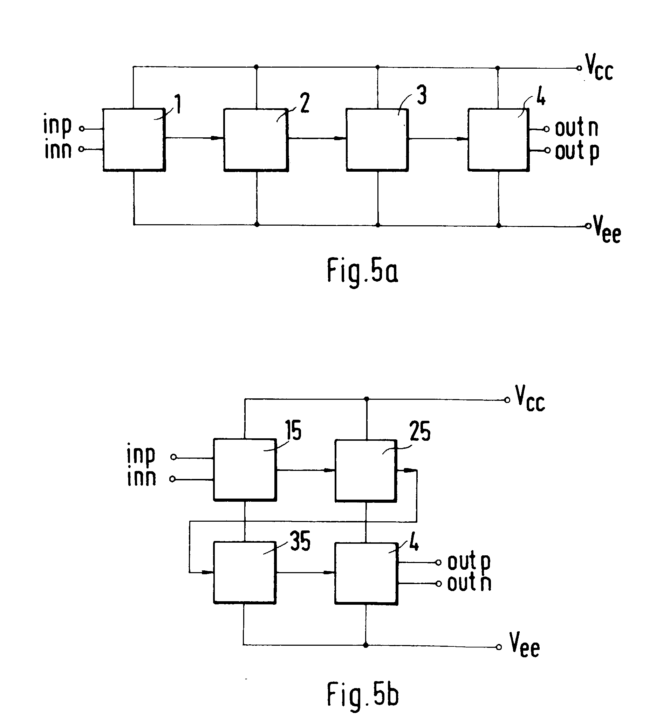

Bei einem vierstufigen Emitterfolger gemäß Fig. 5b, wird eine Reduzierung der Stromaufnahme gegenüber einer konventionellen Parallelschaltung gemäß Fig. 5a um 50% erzielt. Dazu ist eine Neudimensionierung der ersten Stufe 1, der zweiten Stufe 2 und der dritten Stufe 3 des Emitterfolgers erforderlich, die in der erfindungsgemäßen Schaltungsanordnung gemäß Fig. 5b als Stufe 15, Stufe 25 und Stufe 35 gekennzeichnet sind. Somit besteht in diesem Beispiel die erfindungsgemäße Schaltungsanordnung aus zwei parallel geschalteten Zweigen, von denen jeder aus einer Reihenschaltung zweier Emitterfolger besteht.

Es ist möglich, auch mehr als zwei Emitterfolger in je einem Zweig unter Beibehaltung der Größe der Eingansspannungen und der Ausgangsspannungen in Reihe zu schalten, wenn die Versorgungsspannung eine derartige Realisierung zuläßt. Die Stromaufnahme nimmt dann entsprechend ab.

Zu dem Ausführungsbeispiel sei angemerkt, daß die einzelnen Stufen der Emitterfolger hinsichtlich der Stromversorgung parallel geschaltet oder parallel-reihen-geschaltet sind. Bezüglich der Informationsübertragung sind die Emitterfolger in Kette geschaltet.

## Patentansprüche

1. Schaltungsanordnung für eine digitale Schaltung mit differentieller Logik mit einer Vielzahl in Kette geschalteter Schaltstufen (1, 2, 3), die aus parallel geschalteten Strompfaden (I1, I2) bestehen, **dadurch gekennzeichnet,** daß unter Beibehaltung der Größe der Versorgungsspannung (V_{cc}, Vₑₑ) und der Eingangsspannungen (inp, inn) und der Ausgangsspannungen (outp, outn) mindestens eine der Schaltstufen (12) in Reihe zu einer weiteren Schaltstufe (3) geschaltet ist, so daß die Anzahl der parallel geschalteten Strompfade reduziert wird.

2. Schaltungsanordnung nach Anspruch 1, dadurch gekennzeichnet, daß bei einem dreistufigen Emitterfolger eine erste Emitterfolgerstufe (14) in Reihe mit einer dritten Emitterfolgestufe (3) geschaltet ist und die dritte Emitterfolgerstufe (3) über eine zweite Emitterfolgerstufe (2) von der ersten Emitterfolgerstufe (1) angesteuert wird und daß die zweite Emitterfolgerstufe (2) und die Reihenschaltung aus der ersten Emitterfolgerstufe (14) und der dritten Emitterfolgerstufe (3) an die Versorgungsspannung (V_{cc}, Vₑₑ) geschaltet sind.

3. Schaltungsanordnung nach Anspruch 1, dadurch gekennzeichnet, daß bei einem vierstufigen Emitterfolger die erste Emitterfolgerstufe (15) in Reihe mit der dritten Emitterfolgerstufe (35) und die zweite Emitterfolgerstufe (25) in Reihe mit einer vierten Emitterfolgerstufe (4) geschaltet ist und diese Reihenschaltungen jeweils an einer Versorgungsspannung (V_{cc}, Vₑₑ) liegen und daß die Informationsübertragung von der ersten (15) über die zweite (25) und die dritte (35) zu der vierten Emitterfolgerstufe (4) erfolgt.
